# EUROPÄISCHE PATENTSCHRIFT

(11) **EP 3 580 767 B1**
(45) Veröffentlichungstag und Bekanntmachung des Hinweises auf die Patenterteilung: **08.06.2022**
(21) Anmeldenummer: 18707236.8
(22) Anmeldetag: 07.02.2018
(51) Int. Cl.: H01C 1/012, H01C 7/02, H01C 1/028, H01C 1/14, H05B 3/26

(54) **HEIZ- UND/ODER KÜHLVORRICHTUNG FÜR EINEN FESTKÖRPER ODER EINEN FLUIDSTROM**
HEATING AND/OR COOLING APPARATUS FOR A SOLID BODY OR A FLUID FLOW
DISPOSITIF DE CHAUFFAGE ET/OU DE REFROIDISSEMENT POUR UN CORPS SOLIDE OU UN FLUX DE FLUIDE

(30) Priorität: 08.02.2017 DE 102017001461
(43) Veröffentlichungstag der Anmeldung: 18.12.2019
(73) Patentinhaber: Gebr. Krallmann GmbH, 32120 Hiddenhausen (DE)
(72) Erfinder: BREXELER, Ingo, 58300 Wetter/Ruhr (DE)
(74) Vertreter: Lichti - Patentanwälte Partnerschaft mbB
(86) Internationale Anmeldenummer: PCT/EP2018/000052
(87) Internationale Veröffentlichungsnummer: WO 2018/145811

(56) Entgegenhaltungen:
- EP-A1- 0 262 243
- EP-A2- 1 573 753
- US-A- 5 598 502

## Beschreibung

Die Erfindung betrifft eine Heiz- und/oder Kühlvorrichtung für einen Festkörper oder einen Fluidstrom und ein Verfahren zur Herstellung einer entsprechenden Heiz- und/oder Kühlvorrichtung.

Ferner betrifft die Erfindung einen Werkzeug-Handgriff mit einer entsprechenden Heiz- und/oder Kühlvorrichtung, ein Kameragehäuse und/oder -handgriff mit einer entsprechenden Heiz- und/oder Kühlvorrichtung und eine Kfz-Abgasvorrichtung, in die eine entsprechende Heiz- und/oder Kühlvorrichtung integriert ist.

In vielen Bereichen der Industrie ist es notwendig, Gasgemische, Flüssigkeiten oder auch Festkörper auf engstem Raum zu temperieren, d.h. zu erwärmen oder zu kühlen. Im Folgenden wird beispielhaft von der Erwärmung eines Festkörpers ausgegangen, jedoch ist die Erfindung darauf nicht beschränkt.

Bei einem entsprechenden Festkörper kann es sich beispielsweise um einen beheizbaren Handgriff eines Werkzeugs, z.B. einer Motorsäge, oder einer Kamera oder um ein Kameragehäuse handeln. Die Erwärmung des Handgriffs oder des Gehäuses dient üblicherweise dazu, die Handhabung des Werkzeugs oder der Kamera für einen Benutzer bei Verwendung außerhalb von Gebäuden und insbesondere in der freien Natur im Winter angenehmer zu machen. Zu diesem Zweck ist eine Heizvorrichtung bekannt, die eine dünnwandige Platte aus rostfreiem Stahl umfasst. Auf der Außenoberfläche der Platte wird ein vorgefertigtes Heizelement, insbesondere ein sogenannter PTC-Widerstand oder PTC-Thermistor (Positive Temperature Coefficient Thermistor) angeordnet. Dabei handelt es sich um einen temperaturabhängigen Widerstand, der bei tiefen Temperaturen den elektrischen Strom besser als bei hohen Temperaturen leitet. Das Heizelement wird auf der Außenseite der Platte befestigt und insbesondere angelötet. Dies so gebildete Zwischenprodukt wird dann in eine Kunststoff-Spritzgussvorrichtung eingesetzt und mit einer Kunststoffhülle umspritzt, wodurch das Heizelement relativ zu der rohrförmigen Platte sicher positioniert ist. Dieses Vorgehen erfordert eine Vielzahl unterschiedlicher Verfahrensschritte und ist auf diese Weise sehr aufwändig und kostenintensiv.

Gemäß einem weiteren Anwendungsbeispiel wird eine entsprechende Heizvorrichtung in der Kfz-Industrie verwendet. Insbesondere in Dieselmotoren ist es bekannt, zur Abgasnachbehandlung oder zur Reduktion von Stickoxiden eine harnstoffwässrige Lösung in den Abgasstrom vor dem Katalysator einzubringen. Dazu ist es bei relativ tiefen Außentemperaturen notwendig, die harnstoffwässrige Lösung durch Erwärmen auf einer gewünschten Betriebstemperatur zu halten. Darüber hinaus muss die Lösung bei tiefen Außentemperaturen während des Stillstands des Fahrzeugs erwärmt und aufgetaut werden. Eine dafür verwendete Heizvorrichtung weist eine dünnwandige Hülse auf, an der ein PTC-Widerstand oder PTC-Thermistor befestigt wird. Dieses Zwischenprodukt wird in einer Kunststoff-Spritzgussvorrichtung in genannter Weise umspritzt. Auch dieses Vorgehen ist sehr aufwändig.

US 5,598,502 und EP 0 262 243 offenbaren Heiz- und/oder Kühlvorrichtungen gemäß dem Oberbegriff von Anspruch 1.

Der Erfindung liegt die Aufgabe zugrunde, eine Heiz- und/oder Kühlvorrichtung der genannten Art zu schaffen, die sich in einfacher und kostengünstiger Weise herstellen lässt.

Darüber hinaus soll ein Verfahren zur Herstellung einer entsprechenden Heiz- und/oder Kühlvorrichtung geschaffen werden, das einfach und kostengünstig durchführbar ist. Diese Aufgabe wird hinsichtlich der Vorrichtung erfindungsgemäß durch eine Heiz- und Kühlvorrichtung mit den Merkmalen des Anspruchs 1 gelöst.

Die Erfindung geht von der Grundüberlegung aus, die Heiz- und/oder Kühlvorrichtung aus einem vorgefertigten Heiz- und/oder Kühlelement, beispielsweise einem PTC-Thermistor oder einem Peltierelement aufzubauen und das Heiz- und/oder Kühlelement mit einem aus Kunststoff bestehenden, gespritzten Trägerteil zu verbinden und auch die elektrischen Anschlüsse sowie ein metallenes Verteilerelement, das zur Wärme- oder Kälteverteilung über einen vorbestimmten Flächenbereich dient, mittels Metallspritzen oder Metallgießen auszubilden.

Die erfindungsgemäße Heiz- und/oder Kühlvorrichtung für einen einen Festkörper oder einen Fluidstrom besitzt ein aus Kunststoff bestehendes Trägerteil, bei dem es sich um eine Trägerplatte oder auch um ein rohrförmiges Trägerteil halten kann. In dem Trägerteil ist das vorgefertigte elektrisehe Heiz- und/oder Kühlelement gehalten und eingebettet. Mit dem Heiz- und/oder Kühlelement steht das metallene Verteilerelement in Kontakt, das beispielsweise vorher oder nachträglich angespritzt sein kann. Insbesondere sind zumindest ein Anschlusskontakt und insbesondere zumindest zwei Anschlusskontakte vorgesehen, über die eine externe elektrische Spannungsquelle angeschlossen werden kann. Bei den Anschlusskontakten kann es sich um vorgefertigte Bauteile handeln, die in die Spritzgussvorrichtung eingesetzt werden, alternativ ist es jedoch auch möglich, die Anschlusskontakte ebenfalls mittels des Metallspritz- oder Metallgießverfahrens auszubilden. Darüber hinaus ist eine elektrische Leiterbahn vorgesehen, die einen der Anschlusskontakte mit dem Heiz- und Kühlelement verbindet. Der andere Anschlusskontakt kann über das metallische Verteilerelement mit dem Heiz- und/oder Kühlelement verbunden sein.

In bevorzugter Ausgestaltung der Erfindung ist vorgesehen, dass das Heiz- und/oder Kühlelement zumindest formschlüssig in dem Trägerteil aus Kunststoff gehalten ist. Zusätzlich oder alternativ zu der formschlüssigen Halterung kann eine kraftschlüssige Halterung beispielsweise über eine Haftkraft oder eine Klebkraft vorhanden sein.

Bei dem metallenen Verteilerelement kann es sich beispielsweise um eine ebene oder eine gekrümmte Platte oder auch um ein Rohrelement handeln. Jedoch sind auch andere Geometrien denkbar.

Um einen sicheren, dauerhaften Kontakt zwischen dem Kühl- und/oder Heizelement und dem Verteilerelement zu gewährleisten, so dass eine gute Wärmeübertragung und auch ein elektrischer Stromfluss zwischen diesen Bauteilen gegeben ist, kann in Weiterbildung der Erfindung vorgesehen sein, dass das metallene Verteilerelement mit dem Heiz- und/oder Kühlelement fest verbunden und insbesondere verlötet ist. Die feste Verbindung und insbesondere die Lötverbindung wird unmittelbar beim Einbringen der Metallschmelze gebildet, ohne dass für die Verbindung weitere Arbeitsschritte notwendig sind. Vorzugsweise ist die mit der Metallschmelze zu verbindende Oberfläche des Heiz- und/oder Kühlelementes vorbehandelt. Dabei kann es sich um eine Plasma-Vorbehandlung und/oder um das Aufbringen eines Kontaktmittels oder eines Flussmittels handeln.

Das metallene Verteilerelement besteht vorzugsweise aus einer spritzfähigen Metallschmelze und insbesondere einer niedrig legierten Metallschmelze, bei der es sich beispielsweise um Elektroniklot handeln kann. Als Elektroniklot findet üblicherweise ein Weichlot in Form einer Zinn-Legierung Verwendung.

In einer möglichen Ausgestaltung der Erfindung kann vorgesehen sein, dass das metallene Verteilerelement in eine im Trägerteil gebildete Ausnehmung eingebettet oder eingesetzt ist.

Vorzugsweise ist das Verteilerelement zumindest formschlüssig an der Trägerplatte gehalten. Alternativ oder zusätzlich dazu kann jedoch auch vorgesehen sein, dass das Verteilerelement kraftschlüssig, beispielsweise mittels einer Haftkraft oder mittels einer Klebekraft an der Trägerplatte gehalten ist.

Die Leiterbahn, die einen der Anschlusskontakte mit dem Heiz- und/oder Kühlelement verbindet, wird vorzugsweise durch Metallspritzen oder Metallgießen hergestellt und kann zu diesem Zweck aus einer niedrig legierten Metallschmelze, insbesondere einem Elektroniklot gebildet sein. Als Elektroniklot findet üblicherweise ein Weichlot in Form einer Zinn-Legierung Verwendung.

Erfindungsgemäß ist die Leiterbahn in eine im Trägerteil gebildete Ausnehmung oder Nut eingebettet und kann in dieser formschlüssig und/oder kraftschlüssig gehalten sein.

Um einen sicheren, dauerhaften Kontakt zwischen dem Kühl- und/oder Heizelement und der Leiterbahn zu gewährleisten, so dass eine gute Wärmeübertragung und auch ein guter elektrischer Stromfluss zwischen diesen Bauteilen gegeben ist, kann in Weiterbildung der Erfindung vorgesehen sein, dass die Leiterbahn mit dem Heiz- und/oder Kühlelement fest verbunden und insbesondere verlötet ist. Die feste Verbindung und insbesondere die Lötverbindung wird unmittelbar beim Einbringen der Metallschmelze gebildet, ohne dass dazu weitere Arbeitsschritte notwendig sind. Vorzugsweise ist die mit der Metallschmelze zu verbindende Oberfläche des Heiz- und/oder Kühlelementes vorbehandelt. Dabei kann es sich um eine Plasma-Vorbehandlung und/oder um das Aufbringen eines Kontaktmittels oder eines Flussmittels handeln. In Weiterbildung der Erfindung kann vorgesehen sein, dass die Leiterbahn an ihrem an dem Heiz- und/oder Kühlelement angeordneten Ende mit einem einstückig angeformten Kontaktteil versehen ist, dass vorzugsweise an die Abmessungen des Heiz- und/oder Kühlelementes angepasst ist, so das eine gute elektrische Verbindung zwischen der Leiterbahn und dem Heiz- und/oder Kühlelement sichergestellt ist.

In einer möglichen Anwendung der genannten Heiz- und/oder Kühlvorrichtung ist diese in einen Handgriff eines Werkzeugs, insbesondere eines motorbetriebenen Werkzeugs, beispielsweise einer Motorsäge, oder in den Handgriff oder das Gehäuse einer Kamera integriert. Hinsichtlich des Aufbaus der in den Handgriff oder das Gehäuse integrierten Heiz- und/oder Kühlvorrichtung wird auf die oben bestehenden Erläuterungen verwiesen.

*Desweitern kann eine Kfz-Abgasvorrichtung vorgesehen sein, die einen Strömungskanal aufweist, in dem das Abgas beispielsweise eines Dieselmotors oder eine Flüssigkeit strömt. Um das Abgas oder die Flüssigkeit auf einer vorbestimmten Temperatur zu halten oder zu bringen, kann in den Strömungskanal eine Heiz- und*/*oder Kühlvorrichtung der genannten Art integriert sein.*

Zur Herstellung der genannten Heiz- und/oder Kühlvorrichtung sind verschiedene Vorgehensweisen, gemäß Ansprüchen 15, 16 und 17, genannt:
In einer ersten möglichen Ausgestaltung des erfindungsgemäßen Verfahrens kann vorgesehen sein, dass zunächst in einer Spritzgussvorrichtung ein aus Kunststoff bestehendes Trägerteil hergestellt wird. Bei dem Trägerteil kann es sich beispielsweise um eine Platte, einem Block oder ein Rohrelement handeln.

Anschließend wird an oder in dem Trägerteil ein vorgefertigtes Heiz- und/oder Kühlelement (PTC-Thermistor oder Peltierelement) angeordnet. Zur exakten Positionierung des Heiz- und/oder Kühlelementes können in dem Trägerteil entsprechende Ausnehmungen, Vertiefungen oder sonstige Positionierhilfen ausgebildet sein.

Anschließend wird in einem Metallspritz- oder Metallgussverfahren ein flüssiges Metall, beispielsweise Elektroniklot, aufgebracht, wodurch an dem Trägerteil zumindest eine und vorzugsweise mehrere aus der Metallschmelze gebildete Leiterbahnen und/oder zumindest ein metallisches Verteilerelement ausgebildet und jeweils mit dem Heiz- und/oder Kühlelement verbunden werden. Erfindungsgemäß sind in dem Trägerteil Vertiefungen oder Nuten vorgesehen, in die die Metallschmelze zur Bildung der Leiterbahnen und des Verteilerelementes eingebracht werden.

Die Leiterbahnen dienen dazu, das Heiz- und/oder Kühlelement vorzugsweise über entweder vorgefertigte oder ebenfalls im Metallspritz- oder Metallgussverfahren ausgebildete Kontaktteile an eine externe elektrische Spannungsquelle anschließen zu können.

Das Verteilerelement dient dazu, beispielsweise die vom Heiz- und/oder Kühlelement erzeugte Wärme über einen größeren Flächenbereich zu verteilen und somit eine größere Kontaktfläche für die Heiz- und/oder Kühlvorrichtung mit dem zu erwärmenden oder zu kühlenden Fluid zu erzielen.

In einem nachfolgenden Verfahrensschritt kann eine außenseitige Schutzhülle aus Kunststoff aufgespritzt werden, um die metallenen Bauteile vor äußeren Einwirkungen zu schützen und diese elektrisch zu isolieren. Die Schutzhülle kann so dimensioniert und geformt sein, dass sie das zu erwärmende und/oder zu kühlende Bauteil, beispielsweise einen Handgriff bildet.

In einer alternativen Ausgestaltung der Erfindung kann vorgesehen sein, dass zunächst ein vorgefertigtes Heiz- und/oder Kühlelement (PTC-Thermistor oder Peltier-Element) in einer Kunststoff-Spritzgussvorrichtung angeordnet und in dieser unter Bildung eines Trägerträgers mit Kunststoff so umspritzt wird, dass das Heiz- und/oder Kühlelement an oder in dem Trägerteil angeordnet und gehalten ist. Anschließend wird das Metallspritz- oder Metallgussverfahren in oben genannter Ausgestaltung zur Bildung der Leiterbahn und/oder des Verteilerelements und/oder der Anschlusskontakte durchgeführt und abschließend gegebenenfalls eine Schutzhülle aus Kunststoff aufgespritzt. Die Schutzhülle kann so dimensioniert und geformt sein, dass sie das zu erwärmende und/oder zu kühlende Bauteil, beispielsweise einen Handgriff bildet.

In einer weiteren alternativen Ausgestaltung des Verfahrens wird zunächst ebenfalls das aus Kunststoff bestehende Trägerteil in genannter Weise hergestellt. Statt jedoch zuerst das vorgefertigte Heiz- und/oder Kühlelement an dem Trägerteil anzubringen, wird zunächst das genannte Metallspritz- oder Metallgussverfahren zur Ausbildung der Leiterbahn und/oder des Verteilerelementes und/oder der Anschlusskontakte durchgeführt, woraufhin das vorgefertigte Heiz- und/oder Kühlelement an dem Trägerteil angebracht und mit der Leiterbahn und/oder dem Verteilerelement elektrisch verbunden wird. Anschließend kann in genannter Weise eine Schutzhülle aus Kunststoff aufgespritzt werden. Die Schutzhülle kann so dimensioniert und geformt sein, dass sie das zu erwärmende und/oder zu kühlende Bauteil, beispielsweise einen Handgriff bildet.

In bevorzugter Ausgestaltung der Erfindung ist vorgesehen, dass das Heiz- und/oder Kühlelement vor dem Einbringen der Metallschmelze einer Plasmabehandlung unterworfen wird. Diese kann insbesondere innerhalb des geschlossenen Spritzgusswerkzeugs erfolgen.

Zusätzlich oder alternativ dazu kann vorgesehen sein, dass das auf das Heiz- und/oder Kühlelement vor dem Einbringen der Metallschmelze ein Kontaktmittel oder ein Flussmittel aufgebracht wird.

Eine feste Verbindung zwischen dem Heiz- und/oder Kühlelement und den damit verbundenen elektrisch leitenden und wärmeleitenden Bauteile, d.h. der Leiterbahn und/oder dem Verteilerelement kann alternativ oder zusätzlich dazu auch dadurch erreicht werden, dass die Bauteile mittels eines elektrisch leitenden und wärmeleitenden Klebers verbunden werden.

Weitere Einzelheiten und Merkmale der Erfindung sind aus der folgenden Beschreibung eines Ausführungsbeispiels unter Bezugnahme auf die Zeichnungen ersichtlich. Es zeigen:
- Fig. 1: eine perspektivische Aufsicht auf eine Heiz- und/oder Kühlvorrichtung gemäß der Erfindung,
- Fig. 2: eine perspektivische Unteransicht der Heiz- und/oder Kühlvorrichtung gemäß Figur 1,
- Fig. 3: eine perspektivische Explosionsdarstellung der Bauteile der Heiz- und/oder Kühlvorrichtung,
- Fig. 4: eine perspektivische Schnittansicht der Heiz- und/oder Kühlvorrichtung gemäß Figur 1 und
- Fig. 5: das Detail V in Figur 4 in vergrößerter Darstellung

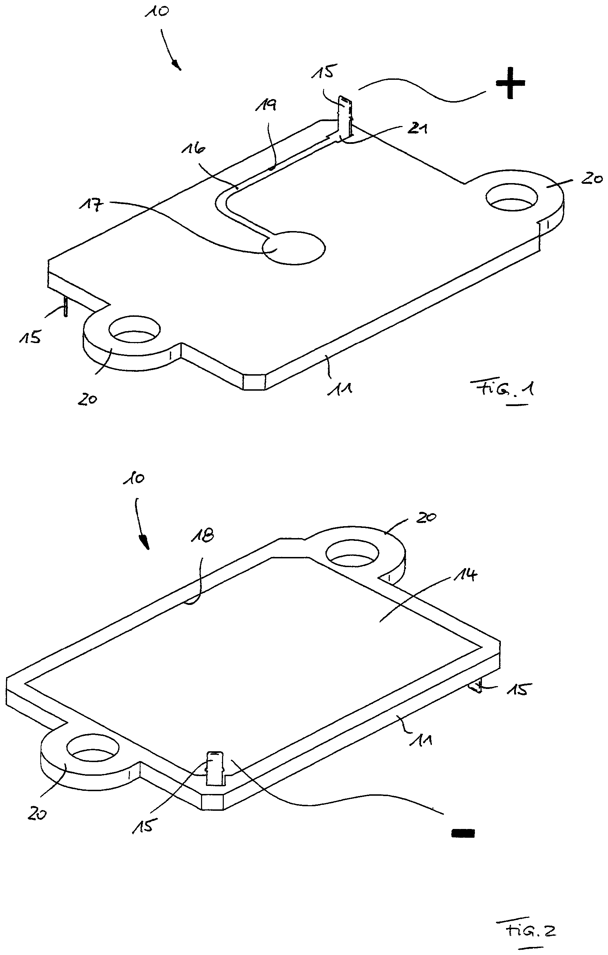

Eine in den Figuren 1 bis 5 dargestellte Heiz- und/oder Kühlvorrichtung 10 für einen Fluidstrom besitzt ein aus Kunststoff bestehendes plattenförmiges Trägerteil 11, in dem eine großflächige Ausnehmung 18, eine Durchbrechung 12 und eine nutförmige Ausnehmung 19 ausgebildet sind, wobei die Ausnehmung 18 und die nutförmige Ausnehmung 19 auf entgegengesetzten Seiten des Trägerteils 11 angeordnet sind.

Auf der Oberseite des Trägerteils 11 sowie der entgegengesetzten Unterseite des Trägerteils 11 ist jeweils in einem Eckbereich ein vorgefertigter Anschlusskontakt 15 angeordnet. Der eine Anschlusskontakt 15 kann mit einem Pluspol einer elektrischen Spannungsquelle verbunden werden (siehe Zeichen "+" in Figur 1), während der andere Anschlusskontakt 15 mit einem Minuspol der elektrischen Spannungsquelle verbunden werden kann (siehe Zeichen "-" in Figur 2).

An dem Trägerteil 11 sind Befestigungsnasen 20 angeformt, die es ermöglichen, die Heiz- und/oder Kühlvorrichtung 10 an dem gewünschten Einsatzort, beispielsweise in einem Fahrzeug zu befestigen.

In die Durchbrechung 12 ist ein vorgefertigtes Heiz- und/oder Kühlelement 13 eingesetzt, bei dem es sich um einen PTC-Thermistor oder ein Peltierelement handeln kann. Im dargestellten Ausführungsbeispiel besitzt das Heiz- und/oder Kühlelement 13 die Form einer flachen Kreisscheibe und die Durchbrechung 12 ist entsprechend mit einem kreisförmigen Querschnitt ausgebildet. Die Abmessungen des Heiz- und/oder Kühlelementes 13 und der Durchbrechung 12 sind so aufeinander abgestimmt, dass das Heiz- und/oder Kühlelement 13 sicher in der Durchbrechung 12 positioniert ist.

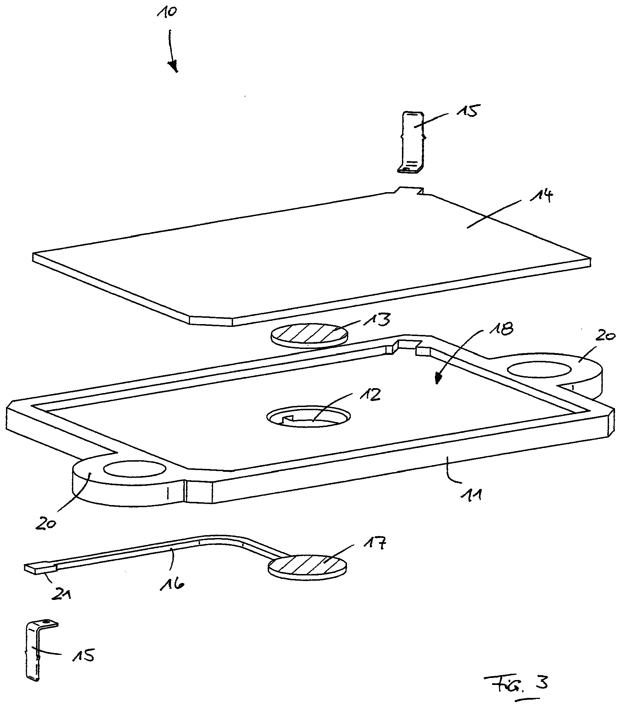

Auf der Oberseite des Trägerteils 11 (siehe Figur 1) ist eine nut- oder kanalförmige Ausnehmung 19 ausgebildet, die zwischen dem auf der Oberseite des Trägerteils 11 angeordneten Anschlusskontakt 15 und der Durchbrechung 12 verläuft und diese beiden Elemente miteinander verbindet. In die Ausnehmung 19 ist eine Leiterbahn 16 eingebracht und insbesondere eingespritzt oder eingegossen, die aus einer Metallschmelze gebildet ist. Die Leiterbahn 16 besitzt an ihrem der Durchbrechung 12 zugewandten Ende ein Kontaktteil 17 vergrößerter Abmessungen. Das Kontaktteil 17 ist im dargestellten Ausführungsbeispiel an die Abmessungen der Durchbrechungen 12 und des Heiz- und/oder Kühlelementes 13 angepasst und somit ebenfalls als flache Kreisscheibe ausgebildet, wie es in Figur 3 dargestellt ist.

Auch an dem dem Kontaktteil 17 abgewandten, dem Anschlusskontakt 15 zugewandten Ende der Leiterbahn 16 ist ein Kontaktteil 21 mit vergrößerten Abmessungen ausgebildet, über das die Leiterbahn 16 mit dem Anschlusskontakt 15 in elektrisch leitender Verbindung steht.

In die großflächige Ausnehmung 18 auf der Unterseite des plattenförmigen Trägerteils 11 ist unter enger Passung ein metallenes, plattenförmiges Verteilerelement 14 eingebracht. Das Verteilerelement 14 kann vorgefertigt sein, vorzugsweise ist es jedoch durch Einspritzen oder Eingießen einer Metallschmelze gebildet und steht mit dem im Eckbereich angeordneten Anschlusselement 15 in elektrisch leitender Verbindung und kontaktiert das Heiz- und/oder Kühlelement 13, so dass auch mit diesem eine elektrisch leitende Verbindung besteht. Das Verteilerelement 14 dient dazu, beispielsweise die von dem Heiz- und/oder Kühlelement 13 erzeugte Wärme auf einen großflächigen Bereich zu verteilen.

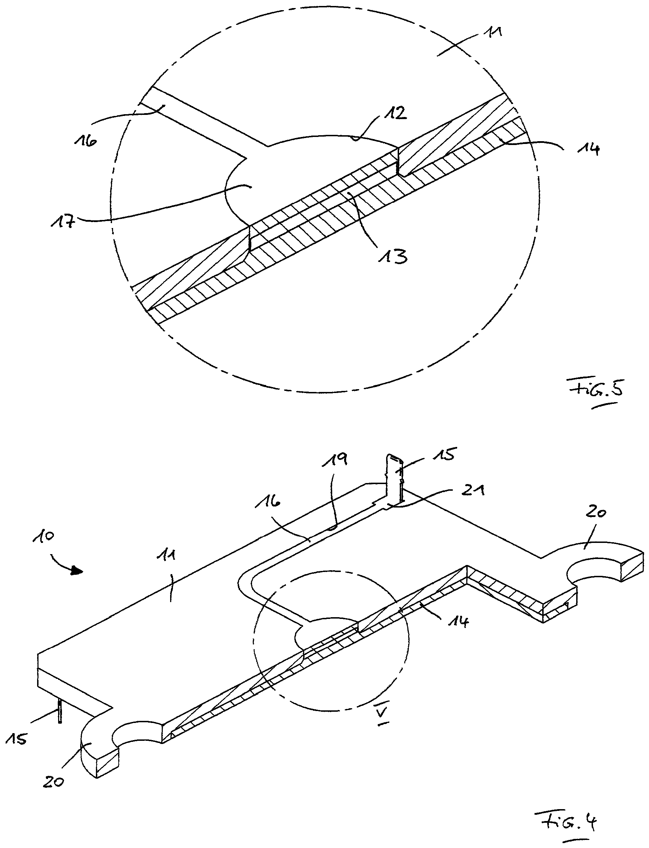

Die Figuren 4 und 5 zeigen, dass das Heiz- und/oder Kühlelement 13 zwischen dem plattenförmigen Verteilerelement 14 und dem Kontaktteil 17 der Leiterbahn 16 unter enger Passung angeordnet ist.

Wenn die Heiz- und/oder die Kühlvorrichtung 10 über die beiden Anschlusskontakte 15 an eine elektrische Spannungsquelle angeschlossen ist, ist das Heiz- und/oder Kühlelemente 13 über die Leiterbahn 16 und das Verteilerelement 14 im Stromkreis angeordnet. Wenn das Heiz- und/oder Kühlelement 13 ein PCT-Thermistator ist, stellt es einen Widerstand dar, an dem Wärme entsteht. Diese Wärme wird an das plattenförmige Verteilerelement 14 abgegeben und großflächig verteilt. Das Verteilerelement 14 dient als Wärmetauscher für ein an der Heiz- und/oder Kühlvorrichtung 10 und insbesondere an dem Verteilerelement 11 vorbeiströmenden Fluid, wodurch dieses erwärmt wird.

## Patentansprüche

1. Heiz- und/oder Kühlvorrichtung (10) für einen Festkörper und/oder einen Fluidstrom, mit einem Trägerteil (11), in das ein elektrisches Heiz- und/oder Kühlelement (13) eingebettet ist, einem mit dem Heiz- und/oder Kühlelement (13) in Kontakt stehenden metallenen Verteilerelement (14), zumindest einem Anschlusskontakt (15) und einer elektrischen Leiterbahn (16), die den Anschlusskontakt (15) mit dem Heiz- und/oder Kühlelement (13) verbindet, **dadurch gekennzeichnet, dass** das Trägerteil (11) aus Kunststoff besteht und dass die Leiterbahn (16) in eine im Trägerteil (11) gebildete Ausnehmung (19) oder Nut eingebettet ist.

2. Heiz- und/oder Kühlvorrichtung nach Anspruch 1, **dadurch gekennzeichnet, dass** als Heizelement ein PTC-Widerstand oder PTC-Thermistor vorgesehen ist.

3. Heiz- und/oder Kühlvorrichtung nach Anspruch 1, **dadurch gekennzeichnet, dass** als Heiz- und/oder Kühlelement ein Peltier-Element vorgesehen ist.

4. Heiz- und/oder Kühlvorrichtung nach einem der Ansprüche 1 bis 3, **dadurch gekennzeichnet, dass** das Heiz- und/oder Kühlelement (13) zumindest formschlüssig in dem Trägerteil (11) gehalten ist.

5. Heiz- und/oder Kühlvorrichtung nach einem der Ansprüche 1 bis 4, **dadurch gekennzeichnet, dass** das metallene Verteilerelement (14) aus einer niedrig legierten Metallschmelze, insbesondere Elektroniklot, gebildet ist.

6. Heiz- und/oder Kühlvorrichtung nach einem der Ansprüche 1 bis 5, **dadurch gekennzeichnet, dass** das metallene Verteilerelement (14) in eine im Trägerteil (11) gebildete Ausnehmung (18) eingebettet ist.

7. Heiz- und/oder Kühlvorrichtung nach einem der Ansprüche 1 bis 6, **dadurch gekennzeichnet, dass** das Verteilerelement (14) zumindest formschlüssig an der Trägerplatte (11) gehalten ist.

8. Heiz- und/oder Kühlvorrichtung nach einem der Ansprüche 1 bis 7, **dadurch gekennzeichnet, dass** die Leiterbahn (16) aus einer niedrig legierten Metallschmelze, insbesondere Elektroniklot, gebildet ist.

9. Heiz- und/oder Kühlvorrichtung nach einem der Ansprüche 1 bis 8, **dadurch gekennzeichnet, dass** die Leiterbahn (16) an ihrem dem Heiz- und/oder Kühlelement (13) angeordneten Ende mit einem einstückig angeformten Kontaktteil (17) versehen ist.

10. Heiz- und/oder Kühlvorrichtung nach einem der Ansprüche 1 bis 9, **dadurch gekennzeichnet, dass** zumindest zwei Anschlusskontakte (15) vorgesehen sind, mittels der das Heiz- und/oder Kühlelement (13) an eine äußere elektrische Spannungsquelle anschließbar ist.

11. Werkzeug-Handgriff mit einer in den Handgriff integrierten Heiz- und/oder Kühlvorrichtung nach einem der Ansprüche 1 bis 10.

12. Kamerahandgriff mit einer in den Handgriff integrierten Heiz- und/oder Kühlvorrichtung nach einem der Ansprüche 1 bis 10.

13. Kameragehäuse mit einer in das Gehäuse integrierten Heiz- und/oder Kühlvorrichtung nach einem der Ansprüche 1 bis 10.

14. Kfz-Abgasvorrichtung mit einem Strömungskanal, in den eine Heiz- und/oder Kühlvorrichtung nach einem der Ansprüche 1 bis 10 integriert ist.

15. Verfahren zur Herstellung einer Heiz- und/oder Kühlvorrichtung (10) nach einem der Ansprüche 1 bis 10, wobei in einer Spritzgussvorrichtung ein aus Kunststoff bestehendes Trägerteil (11) mit Vertiefungen (19) oder Nuten hergestellt wird, wobei anschließend an oder in dem Trägerteil (11) ein vorgefertigtes Heiz- und/oder Kühlelement (13) angeordnet wird und wobei in einem nachfolgenden Metallspritz- oder Metallgussverfahren zumindest eine aus einer Metallschmelze gebildete Leiterbahn (16) und zumindest ein metallisches Verteilerelement (14) an dem Trägerteil (11) ausgebildet und mit dem Heiz- und/oder Kühlelement (13) verbunden wird, wobei die Metallschmelze zur Bildung der Leiterbahn (16) und des Verteilerelements (14) in die Vertiefungen (1) oder Nuten eingebracht wird.

16. Verfahren zur Herstellung einer Heiz- und/oder Kühlvorrichtung (10) nach einem der Ansprüche 1 bis 10, wobei ein vorgefertigtes Heiz- und/oder Kühlelement (13) in einer Spritzgussvorrichtung angeordnet und in dieser unter Bildung eines Trägerteils (11) mit Kunststoff so umspritzt wird, dass es an oder in dem Trägerteil (11) angeordnet und gehalten ist, wobei das Trägerteil (11) Vertiefungen (19) oder Nuten aufweist, und wobei in einen nachfolgenden Metallspritz- oder Metallgussverfahren zumindest eine aus einer Metallschmelze gebildete Leiterbahn (16) und zumindest ein metallisches Verteilerelement (14) an dem Trägerteil (11) ausgebildet und mit dem Heiz- und/oder Kühlelement (13) verbunden wird, wobei die Metallschmelze zur Bildung der Leiterbahn (16) und des Verteilerelements (14) in die Vertiefungen (1) oder Nuten eingebracht wird.

17. Verfahren zur Herstellung einer Heiz- und/oder Kühlvorrichtung (10) nach einem der Ansprüche 1 bis 10, wobei in einer Spritzgussvorrichtung ein aus Kunststoff bestehendes Trägerteil (11) mit Vertiefungen (19) oder Nuten hergestellt wird, wobei in einem nachfolgenden Metallspritz- oder Metallgussverfahren an oder in dem Trägerteil (11) zumindest eine aus einer Metallschmelze gebildete Leiterbahn (16) und zumindest ein metallisches Verteilerelement (14) ausgebildet werden, wobei die Metallschmelze zur Bildung der Leiterbahn (16) und des Verteilerelementes (14) in die Vertiefungen (19) oder Nuten eingebracht wird, und wobei anschließend ein vorgefertigtes Heiz- und/oder Kühlelement (13) in das Trägerteil (11) eingebettet und mit der Leiterbahn (16) und/oder dem Verteilerelement (14) verbunden wird.

## Claims

1. Heating and/or cooling device (10) for a solid and/or for a fluid stream, with a carrier part (11), in which an electrical heating and/or cooling element (13) is embedded, with a metallic distributor element (14) that is in contact with the heating and/or cooling element (13), with at least one terminal contact (15) and with an electrical strip conductor (16), which connects the terminal contact (15) to the heating and/or cooling element (13), **characterized in that** said carrier part (11) consists of plastic and that the strip conductor (16) is embedded in a recess (19) or groove formed in the carrier part (11).

2. Heating and/or cooling device in accordance with claim 1, **characterized in that** a PTC resistor or PTC thermistor is provided as the heating element.

3. Heating and/or cooling device in accordance with claim 1, **characterized in that** a Peltier element is provided as a heating and/or cooling element.

4. Heating and/or cooling device in accordance with one of the claims 1 through 3, **characterized in that** the heating and/or cooling element (13) is held in the carrier part (11) at least in a positive-locking manner.

5. Heating and/or cooling device in accordance with one of the claims 1 through 4, **characterized in that** the metallic distributor element (14) is formed from a low-alloy metal melt, especially electronic solder.

6. Heating and/or cooling device in accordance with one of the claims 1 through 5, **characterized in that** the metallic distributor element (14) is embedded in a recess (18) formed in the carrier part (11).

7. Heating and/or cooling device in accordance with one of the claims 1 through 6, **characterized in that** the distributor element (14) is held at the carrier plate (11) at least in a positive-locking manner.

8. Heating and/or cooling device in accordance with one of the claims 1 through 7, **characterized in that** the strip conductor (16) is formed from a low-alloy metal melt, especially electronic solder.

9. Heating and/or cooling device in accordance with one of the claims 1 through 8, **characterized in that** the strip conductor (16) is provided with a contact part (17) made integrally in one piece at its end arranged at the heating and/or cooling element (13).

10. Heating and/or cooling device in accordance with one of the claims 1 through 9, **characterized in that** at least two terminal contacts (15) are provided, by means of which the heating and/or cooling element (13) can be connected to an external electrical voltage source.

11. Tool handle with a heating and/or cooling device in accordance with one of the claims 1 through 10, which is integrated in the handle.

12. Camera handle with a heating and/or cooling device in accordance with one of the claims 1 through 10, which is integrated in the handle.

13. Camera housing with a heating and/or cooling device in accordance with one of the claims 1 through 10, which is integrated in the housing.

14. Motor vehicle exhaust gas device with a flow duct, in which a heating and/or cooling device in accordance with one of the claims 1 through 10 is integrated.

15. Process for manufacturing a heating and/or cooling device (10) in accordance with one of the claims 1 through 10, wherein a carrier part (11) consisting of plastic and having recesses (19) or grooves is prepared in an injection molding device, wherein a prefabricated heating and/or cooling element (13) is subsequently arranged at or in the carrier part (11), and wherein at least one strip conductor (16) formed from a metal melt and at least one metallic distributor element (14) are formed at the carrier part (11) in a subsequent metal injection molding process or metal casting process and are connected to the heating and/or cooling element (13), wherein the metal melt is introduced into said recesses (19) or grooves for forming said strip conductor (16) and said distributor element (14).

16. Process for manufacturing a heating and/or cooling device (10) in accordance with one of the claims 1 through 10, wherein a prefabricated heating and/or cooling element (13) is arranged in an injection molding device and is coated in this with plastic by injection molding, while forming a carrier part (11), such that it is arranged and held at or in the carrier part (11), wherein said carrier part (11) has recesses (19) or grooves, and wherein at least one strip conductor (16) formed from a metal melt and at least one metallic distributor element (14) are formed at the carrier part (11) in a subsequent metal injection molding process or metal casting process and are connected to the heating and/or cooling element (13), wherein the metal melt is introduced into said recesses (19) or grooves for forming said strip conductor (16) and said distributor element (14).

17. Process for manufacturing a heating and/or cooling device (10) in accordance with one of the claims 1 through 10, wherein a carrier part (11) consisting of plastic and having recesses (19) or grooves is prepared in an injection molding device, wherein at least one strip conductor (16) formed from a metal melt and at least one metallic distributor element (14) are formed at or in the carrier part (11) in a subsequent metal injection molding process or metal casting process, wherein the metal melt is introduced into said recesses (19) or grooves for forming said strip conductor (16) and said distributor element (14) and wherein a prefabricated heating and/or cooling element (13) is subsequently embedded in the carrier part (11) and is connected to the strip conductor (16) and/or to the distributor element (14).

## Revendications

1. Dispositif de chauffage et/ou de refroidissement (10) pour un corps solide et/ou un courant de fluide, avec une partie de support (11) dans laquelle un élément de chauffage et/ou de refroidissement électrique (13) est encastré, avec un élément de répartition métallique (14) en contact avec l'élément de chauffage et/ou de refroidissement (13), avec au moins un contact de raccordement (15) et avec une piste électriquement conductrice (16) qui relie le contact de raccordement (15) avec l'élément de chauffage et/ou de refroidissement (13), **caractérisé en ce que** la partie de support (11) est en matière plastique et que la piste conductrice (16) est encastrée dans un évidement (19) ou une rainure formée dans la partie de support (11).

2. Dispositif de chauffage et/ou de refroidissement selon la revendication 1, **caractérisé en ce que** l'élément chauffant est prévu sous la forme d'une résistance PTC ou d'une thermistance PTC.

3. Dispositif de chauffage et/ou de refroidissement selon la revendication 1, **caractérisé en ce que** l'élément de chauffage et/ou de refroidissement est prévu sous la forme d'un élément Peltier.

4. Dispositif de chauffage et/ou de refroidissement selon l'une quelconque des revendications 1 à 3, **caractérisé en ce que** l'élément de chauffage et/ou de refroidissement (13) est maintenu au moins par complémentarité de formes dans la partie de support (11).

5. Dispositif de chauffage et/ou de refroidissement selon l'une quelconque des revendications 1 à 4, **caractérisé en ce que** l'élément de répartition métallique (14) est formé à partir d'un métal en fusion faiblement allié, notamment d'une soudure électronique.

6. Dispositif de chauffage et/ou de refroidissement selon l'une quelconque des revendications 1 à 5, **caractérisé en ce que** l'élément de répartition métallique (14) est encastré dans un évidement (18) formé dans la partie de support (11).

7. Dispositif de chauffage et/ou de refroidissement selon l'une quelconque des revendications 1 à 6, **caractérisé en ce que** l'élément de répartition (14) est maintenu au moins par complémentarité de formes au niveau de la plaque de support (11).

8. Dispositif de chauffage et/ou de refroidissement selon l'une quelconque des revendications 1 à 7, **caractérisé en ce que** la piste conductrice (16) est formée à partir d'un métal en fusion faiblement allié, notamment d'une soudure électronique.

9. Dispositif de chauffage et/ou de refroidissement selon l'une quelconque des revendications 1 à 8, **caractérisé en ce que** la piste conductrice (16) est pourvue d'une partie de contact (17) formée d'un seul tenant au niveau de son extrémité disposée au niveau de l'élément de chauffage et/ou de refroidissement (13).

10. Dispositif de chauffage et/ou de refroidissement selon l'une quelconque des revendications 1 à 9, **caractérisé en ce qu'**au moins deux contacts de raccordement (15) sont prévus à l'aide desquels l'élément de chauffage et/ou de refroidissement (13) peut être raccordé à une source de tension électrique extérieure.

11. Poignée d'outil avec un dispositif de chauffage et/ou de refroidissement intégré dans la poignée selon l'une quelconque des revendications 1 à 10.

12. Poignée de caméra avec un dispositif de chauffage et/ou de refroidissement intégré dans la poignée selon l'une quelconque des revendications 1 à 10.

13. Carter de caméra avec un dispositif de chauffage et/ou de refroidissement selon l'une quelconque des revendications 1 à 10 intégré dans le carter.

14. Dispositif d'échappement de véhicule automobile avec un canal d'écoulement dans lequel un dispositif de chauffage et/ou de refroidissement selon l'une quelconque des revendications 1 à 10 est intégré.

15. Procédé de fabrication d'un dispositif de chauffage et/ou de refroidissement (10) selon l'une quelconque des revendications 1 à 10, une partie de support (11) composée de matière plastique avec des renfoncements (19) ou des rainures étant fabriquée dans un dispositif de moulage par injection, un élément de chauffage et/ou de refroidissement (13) préfabriqué étant ensuite disposé au niveau de la partie de support (11) ou dans celle-ci et au moins une piste conductrice (16) formée de métal en fusion et au moins un élément de répartition métallique (14) étant réalisé au niveau de la partie de support (11) au cours d'un procédé de coulée ou d'injection de métal et étant relié à l'élément de chauffage et/ou de refroidissement (13), le métal en fusion étant amené dans les renfoncements (1) ou les rainures pour la formation de la piste conductrice (16) et de l'élément de répartition (14).

16. Procédé de fabrication d'un dispositif de chauffage et/ou de refroidissement (10) selon l'une quelconque des revendications 1 à 10, un élément de chauffage et/ou de refroidissement (13) préfabriqué étant disposé dans un dispositif de moulage par injection et étant injecté dans celui-ci en formant une partie de support (11) en matière plastique de telle sorte qu'elle soit disposée et maintenue au niveau de la partie de support (11) ou dans celle-ci, la partie de support (11) comportant des renfoncements (19) ou des rainures et au moins une piste conductrice (16) formée de métal en fusion et au moins un élément de répartition métallique (14) étant réalisé au niveau de la partie de support (11) au cours d'un procédé d'injection ou de coulée de métal suivant et relié à l'élément de chauffage et/ou de refroidissement (13), le métal en fusion étant amené dans les renfoncements (1) ou dans les rainures pour la formation de la piste conductrice (16) et de l'élément de répartition (14).

17. Procédé de fabrication d'un dispositif de chauffage et/ou de refroidissement (10) selon l'une quelconque des revendications 1 à 10, une partie de support (11) composée de matière plastique dotée de renfoncements (19) ou de rainures étant fabriquée dans un dispositif de moulage par injection, au moins une piste conductrice (16) formée de métal en fusion et au moins un élément de répartition métallique (14) étant réalisés au niveau de la partie de support (11) ou dans celle-ci au cours d'un procédé de coulée ou d'injection de métal suivant, le métal en fusion étant amené dans les renfoncements (19) ou dans les rainures pour la formation de la piste conductrice (16) et de l'élément de répartition (14) et un élément de chauffage et/ou de refroidissement (13) préfabriqué étant ensuite encastré dans la partie de support (11) et relié à la piste conductrice (16) et/ou à l'élément de répartition (14).
